# EUROPÄISCHE PATENTSCHRIFT

(11) **EP 1 716 270 B1**
(45) Veröffentlichungstag und Bekanntmachung des Hinweises auf die Patenterteilung: **22.07.2020**
(21) Anmeldenummer: 05716621.7
(22) Anmeldetag: 02.02.2005
(51) Int. Cl.: C23C 16/46, C23C 16/52, C23C 16/455

(54) **CVD-REAKTOR MIT FOTODIODEN-ARRAY**
CVD REACTOR COMPRISING A PHOTODIODE ARRAY
REACTEUR CVD COMPRENANT UN JEU ORDONNE DE PHOTODIODES

(30) Priorität: 18.02.2004 DE 102004007984
(43) Veröffentlichungstag der Anmeldung: 02.11.2006
(73) Patentinhaber: Aixtron SE, 52134 Herzogenrath (DE)
(72) Erfinder: MULLINS, John Trevor, Somersham PE28 3EX (GB); KAEPPELER, Johannes, 52146 Würselen (DE); SAYWELL, Victor, GT Barton IP31 25W (GB)
(74) Vertreter: Grundmann, Dirk
(86) Internationale Anmeldenummer: PCT/EP2005/050456
(87) Internationale Veröffentlichungsnummer: WO 2005/080632

(56) Entgegenhaltungen:
- EP-A- 1 119 024
- WO-A-02/08487
- DE-A1- 10 116 222
- US-A- 5 885 352
- US-A1- 2003 038 112
- US-B1- 6 221 770
- PATENT ABSTRACTS OF JAPAN Bd. 1996, Nr. 11, 29. November 1996 (1996-11-29) -& JP 08 170176 A (HITACHI LTD; HITACHI ELECTRON ENG CO LTD), 2. Juli 1996 (1996-07-02)
- PATENT ABSTRACTS OF JAPAN Bd. 2003, Nr. 02, 5. Februar 2003 (2003-02-05) -& JP 2002 289601 A (HITACHI KOKUSAI ELECTRIC INC), 4. Oktober 2002 (2002-10-04)

## Beschreibung

Die Erfindung betrifft eine Vorrichtung gemäß Gattungsbegriff des Anspruchs 1.

Eine gattungsgemäße Vorrichtung ist aus der US 2003/0038112 A1 bekannt. Die dort beschriebene Vorrichtung besitzt ein Reaktorgehäuse mit einer darin angeordneten Prozesskammer. Innerhalb der Prozesskammer befindet sich in horizontaler Anordnung ein Substrathalter zur Aufnahme ein oder mehrerer Substrate. Oberhalb des Substrathalters ist ein Gaseinlassorgan vorgesehen. Letzteres bildet eine Frontplatte aus, die dem Substrathalter gegenüberliegt. In der Frontplatte ist eine Vielzahl von vertikalen Kanälen vorgesehen zum Austritt eines Prozessgases, welches in eine oberhalb der Frontplatte angeordnete Kammer eingebracht wird. Die Austrittsöffnungen werden von Vertikalkanälen gebildet. In einige der Vertikalkanäle sind von der Kammer her Sensorköpfe eingesetzt. Mittels an der Glasfaserleitung können optische Informationen aus der Prozesskammer gewonnen werden.

Die JP 08170176 A beschreibt einen VPC-Reaktor mit einem Showerhead und einem darunter angeordneten Suszeptor zur Aufnahme eines Substrates. Der Showerhead besitzt eine Frontplatte mit Öffnungen und eine Rückwand. Die Frontplatte und die Rückwand begrenzen eine Kammer aus der ein Prozessgas durch Öffnungen der Frontplatte in die Prozesskammer strömen kann. Die Rückwand trägt einen optischen Sensor, mit dem die Temperatur der Frontplatte gemessen werden soll.

Aus der WO 02/08487 A1 ist ein CVD-Reaktor bekannt mit einem Showerhead, der eine Vielzahl von Austrittssegmenten für Prozessgase aufweist. Jedem der Segmente ist eine Analyseleitung zugeordnet, die über eine Kapillare mit einer Analyseeinrichtung verbunden ist.

Aus der EP 0 687 749 B1 ist ein MOCVD-Reaktor mit einer rotationssymmetrischen Prozesskammer vorbekannt, deren Boden ein Substrathalter bildet. Die dem Boden gegenüberliegende Decke der Prozesskammer besitzt eine Vielzahl dünner und eng benachbarter Austrittsöffnungen, wobei dort die Austrittsöffnungen abwechselnd mit zwei verschiedenen rückwärtigen Kammern verbunden sind. In diese Kammern werden voneinander verschiedene Gase eingeleitet, die dann durch die Austrittsöffnungen in die Prozesskammer hineinströmen

MOCVD-Reaktoren mit einem duschkopfartigen Gaseinlassorgan sind darüber hinaus auch aus den DE 101 36 858 A1 und DE 102 17 806 A1 vorbekannt.

Die US 6500266 B1 beschreibt einen Reaktor, bei dem zur Temperaturkalibrierung ein extra Deckel vorgesehen ist.

Der Erfindung liegt die Aufgabe zugrunde, die Sensoranordnung bei einer gattungsgemäßen Vorrichtung zu verbessern.

Gelöst wird die Aufgabe durch die in den Ansprüchen angeordnete Erfindung.

Der Anspruch 1 sieht zunächst und im wesentlichen vor, dass die Sensoren entfernt von der Frontplatte angeordnet sind. Die Sensoren befinden sich rückwärtig der Austrittsöffnungen und in Fluchtlage zur Achse der Austrittsöffnungen, so dass sie die Oberflächentemperatur des Substrathalters bzw. eines auf dem Substrathalter aufliegenden Substrates unmittelbar unterhalb der Austrittsöffnung messen können. In einer Weiterbildung der Erfindung ist vorgesehen, dass die Sensoren Fotodioden sind. Die Sensoren können einer mit Abstand rückwärtig einer die Austrittsöffnungen aufweisenden Frontplatte angeordneten Rückwand des Gaseinlassorganes zugeordnet sein. Das Gaseinlassorgan kann wie aus der EP 0 687 749 B1 bekannt, mehrere Kammern aufweisen. Bei einer solchen Ausgestaltung liegen die Fotodioden vorzugsweise rückwärtig der längsten, sich an die Austrittsöffnungen anschließenden Kanäle. Die Sensoren können rückwärtig einer von einer Fensterscheibe verschlossenen Fensteröffnung der Rückwand angeordnet sein. Diese Fensteröffnung kann eine kreisförmige Gestalt aufweisen. In die Fensteröffnung wird die Fensterscheibe, die aus Quarzglas bestehen kann, eingelegt. Sie liegt dort abgedichtet gegenüber den Gasen innerhalb der Kammer. Rückwärtig der Fensterscheibe kann sich eine Leiterplatte befinden, auf welcher reihenförmig die Sensoren angeordnet sind. Vorzugsweise sind die Sensoren in zwei oder mehr Reihen angeordnet, die sich in Radialrichtung ausgehend von der Mitte des Gaseinlassorganes zum Rand hin erstrecken. Die Sensoren der einzelnen Reihen können versetzt zueinander angeordnet sein. Vorzugsweise dreht sich der Substrathalter während des Betriebes gegenüber dem Gaseinlassorgan. Die Prozesskammer und das Gaseinlassorgan haben dann eine kreissymmetrische Gestalt. Die Sensoranordnung erstreckt sich in diesem Falle über einen Halbmesser des Gaseinlassorganes. Zufolge der erfindungsgemäßen Ausgestaltung können zusätzliche und insbesondere größere Bohrungen im Gaseinlasskopf vermieden werden.

Ein Ausführungsbeispiel der Erfindung wird nachfolgend anhand beigefügter Zeichnungen erläutert. Es zeigen:
- Fig. 1: in schematischer Darstellung den Querschnitt durch eine Prozesskammer und das zugehörige Gaseinlassorgan eines ersten Ausführungsbeispieles,
- Fig. 2: die Draufsicht auf das Gaseinlassorgan eines zweiten Ausführungsbeispieles und
- Fig. 3: einen Schnitt gemäß der Linie III-III in Fig. 2.

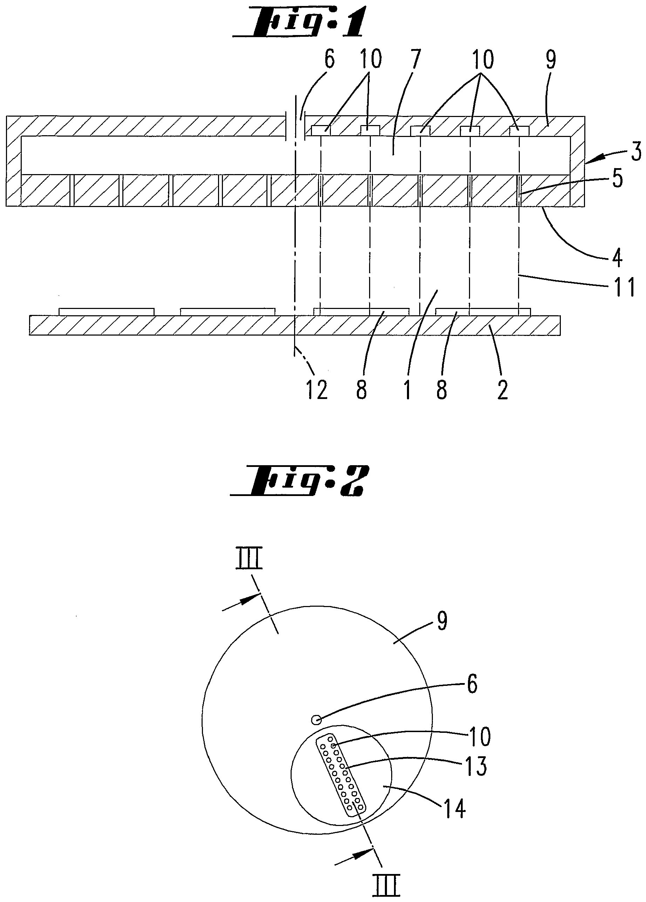

Das in der Fig. 1 dargestellte Ausführungsbeispiel zeigt grobschematisch eine Prozesskammer 1, deren Boden 2 ein Substrathalter bildet. Der Boden 2 erstreckt sich in der Horizontalebene und ist um die Achse 12 drehantreibbar.

Ein Gaseinlassorgan 3 bildet die Decke der Prozesskammer 1. Die vom Gaseinlassorgan 3 ausgebildete Gasaustrittsfläche 4 erstreckt sich parallel zur Oberfläche des Substrathalters 2, auf welcher die Substrate 8 aufliegen. Die Gasaustrittsfläche 4 besitzt eine Vielzahl rasterartig angeordneter Austrittsöffnungen 5. Die Austrittsöffnungen 5 werden von einer Frontplatte des Gaseinlassorganes ausgebildet. Die Austrittsöffnungen 5 sind dünne, eng benachbarte Bohrungen, die rückwärtig in eine Kammer 7 mündet, die von einer Rückwand 9 begrenzt wird. In den Zeichnungen sind die Austrittsöffnungen 5 übertrieben weit beabstandet dargestellt.

In die Kammer 7 strömt durch eine zentrale Zuleitung 6 ein Prozessgas ein, welches im Wesentlichen gleichmäßig verteilt durch die Austrittsöffnungen 5 in die Prozesskammer 1 einströmt.

Die Austrittsöffnungen 5 bilden in Vertikalrichtung sich erstreckende parallele optische Pfade 11 aus.

Fluchtend zur Achse der Austrittsöffnungen 5 befinden sich der Rückwand 9 zugeordnet Fotodioden 10. Die Fotodioden 10 sind reihenförmig angeordnet, so dass die Oberflächentemperatur des Substrathalters 2 an vielen, radial voneinander beabstandeten Positionen gemessen werden kann. Von den Fotodioden 10 wird dabei die von dem Substrathalter 2 bzw. die von dem auf dem Substrathalter 2 aufliegenden Substraten 8 abgegebene Wärmestrahlung gemessen, die entlang der optischen Pfade 11 durch die Austrittsöffnungen 5 in die Kammer 7 zu den Fotodioden 10 gelangt.

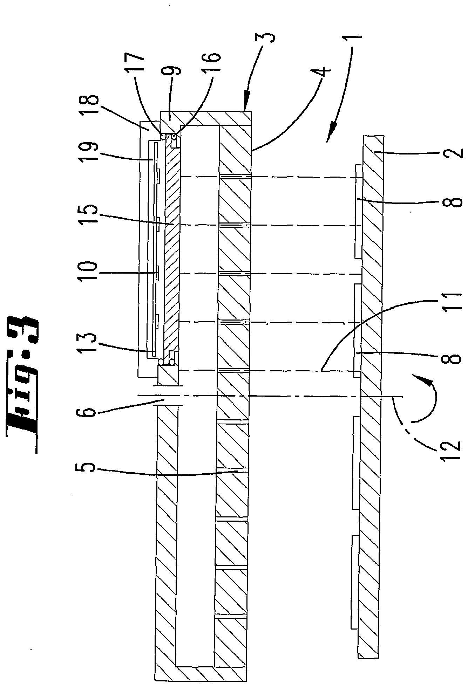

Bei dem in den Figuren 2 und 3 dargestellten Ausführungsbeispiel befinden sich die Fotodioden 10 ebenfalls in einer Rückwand 9 eines Gaseinlassorganes 3. Bei diesem Ausführungsbeispiel besitzt die Rückwand 9 eine kreisförmige Öffnung 14. Diese Öffnung 14 ist von einer wärmestrahlungsdurchlässigen Fensterscheibe 15, beispielsweise aus Quarzglas verschlossen. Zur Abdichtung dienen Dichtringe 16,17 auf denen der Rand der Fensterscheibe 15 aufliegt. Rückwärtig der Fensterscheibe 15 befindet sich eine Leiterplatte 13. Auf dieser Leiterplatte 13 befinden sich zwei Reihen von Fotodioden 10. Die Reihen erstrecken sich in Radialrichtung zum Zentrum bzw. zur Zuleitung 6. Die Fotodioden 10 der beiden Reihen, die auf Leiterplatte 13 angeordnet sind, liegen versetzt zueinander. Der Abstand der Fotodioden 10 auf der Leiterplatte 3 entspricht dabei dem Abstand der Austrittsöffnungen 5 voneinander. Die Leiterplatte kann innerhalb eines die Fensteröffnung 14 rückwärtig verschließenden Gehäuses 18 so lagejustiert werden, dass die einzelnen Fotodioden 10 mit den zugeordneten Öffnungen 5 fluchten.

Das Gehäuse 18 kann mit der Rückwand 9 verschraubt werden.

Die von den Fotodioden 10 empfangenen Signale können in bekannter Weise von einer Datenerfassungseinrichtung oder einer Steuereinrichtung für die Heizung des Substrathalters weitergeleitet werden. Dies kann parallel oder sequentiell über Multiplexe erfolgen.

Durch die Array-förmige Anordnung einer Vielzahl von Fotodioden kann über den gesamten Radius die Temperatur der sich unterhalb des Showerheads drehenden Oberfläche gemessen werden. Dabei kann nicht nur die Oberflächentemperatur des Substrathalters 2, sondern auch die Oberflächentemperatur der Substrate 8 gemessen werden. Die Sensoren 10 können auch aktive Sensoren sein. Sie können beispielsweise Licht einer gewissen Wellenlänge imitieren, welches von den Oberflächen der Substrate reflektiert wird. Auf diese Weise lassen sich weitere Eigenschaften der im Moment abgeschiedenen Schicht bestimmen.

Es wird als besonderer Vorteil der erfindungsgemäßen Vorrichtung angesehen, dass die Temperaturen oder anderweitigen Eigenschaften während des Schichtwachstums bestimmt werden können. Die ohnehin vorhandenen Austrittsöffnungen 5 werden als optische Kanäle benutzt. Da die Austrittsöffnungen 5 permanent durch die Prozessgase gespült werden und das Gaseinlassorgan 3 auf Temperaturen unterhalb der Zerlegungstemperatur der Prozessgase gekühlt werden kann, ist eine Belegung der Oberfläche der Sensoren 10 wirksam verhindert. Auch eine Belegung der Fensterscheibe 15 wird durch die permanente Spülung verhindert, so dass die Vorrichtung einen sehr geringen Wartungsaufwand bedarf.

Die zu den Austrittsöffnungen 5 zugeordneten Kanäle innerhalb des Showerheads haben einen Durchmesser von etwa 0,7 mm.

## Patentansprüche

1. Vorrichtung zum Abscheiden insbesondere kristalliner Schichten auf insbesondere kristallinen Substraten, mit einer in einem Reaktorgehäuse angeordneten Prozesskammer (1), welche einen Substrathalter (2) aufweist zur Aufnahme ein oder mehrerer Substrate (8), welchem Substrathalter (2) ein Gaseinlassorgan (3) gegenüberliegt, dessen auf den Substrathalter (2) weisende, eine Gasaustrittsfläche (4) ausbildende Frontplatte eine Vielzahl im Wesentlichen gleichmäßig verteilter Austrittsöffnungen (5) zum Austritt eines Prozessgases aus einer von der Frontplatte und einer Rückwand (9) begrenzten Kammer (7), wobei eine Vielzahl von Sensoren (10) vorgesehen sind, die jeweils einer Austrittsöffnung (5) zugeordnet und in Fluchtlage zur Achse der zugeordneten Austrittsöffnung (5) angeordnet sind und die Austrittsöffnungen als optische Pfade nutzen, um die Oberflächentemperatur des Substrathalters (2) beziehungsweise eines auf dem Substrathalter (2) aufliegenden Substrates (8) zu messen, **dadurch gekennzeichnet, dass** sich die Sensoren (10) rückwärtig der Frontplatte in der Rückwand (9) befinden oder rückwärtig einer von einer Fensterscheibe (15) verschlossenen Fensteröffnung (14) der Rückwand (9) angeordnet sind.

2. Vorrichtung nach Anspruch 1, **dadurch gekennzeichnet, dass** die Sensoren (10) Fotodioden sind.

3. Vorrichtung nach einem der vorhergehenden Ansprüche, **dadurch gekennzeichnet, dass** die Sensoren (10) reihenförmig auf einer Leiterplatte (13) sitzen.

4. Vorrichtung nach einem der vorhergehenden Ansprüche, **dadurch gekennzeichnet, dass** die Sensoren (10) in zwei oder mehr in Radialrichtung sich erstreckenden Reihen versetzt zueinander angeordnet sind.

5. Vorrichtung nach einem der vorhergehenden Ansprüche, **dadurch gekennzeichnet, dass** die Prozesskammer (1) und das Gaseinlassorgan (3) eine kreissymmetrische Gestalt haben, der Substrathalter (2) relativ zu dem Gaseinlassorgan (3) drehbar ist und sich die Sensoranordnung (10) über einen Halbmesser des Gaseinlassorganes (3) erstreckt.

## Claims

1. Device for depositing in particular crystalline layers on in particular crystalline substrates, comprising a process chamber (1) that is arranged in a reactor housing and has a substrate holder (2) for receiving one or more substrates (8), which substrate holder (2) is opposite a gas inlet member (3) of which the front panel, which faces the substrate holder (2) and forms a gas outlet surface (4), has a large number of substantially uniformly distributed outlet openings (5) for the outlet of a process gas from a chamber (7) that is delimited by the front panel and a rear wall (9), a large number of sensors (10) being provided which are each associated with an outlet opening (5), are arranged in alignment with the axis of the associated outlet opening (5) and use the outlet openings as optical paths to determine the surface temperature of the substrate holder (2) or of a substrate (8) resting on the substrate holder (2), **characterised in that** the sensors (10) are located to the rear of the front panel in the rear wall (9) or to the rear of a window opening (14) in the rear wall (9) that is closed by a window pane (15).

2. Device according to claim 1, **characterised in that** the sensors (10) are photodiodes.

3. Device according to either of the preceding claims, **characterised in that** the sensors (10) are in rows on a printed circuit board (13).

4. Device according to any of the preceding claims, **characterised in that** the sensors (10) are arranged so as to be offset from one another in two or more rows that extend in the radial direction.

5. Device according to any of the preceding claims, **characterised in that** the process chamber (1) and the gas inlet member (3) have a shape that has circular symmetry, the substrate holder (2) can be rotated relative to the gas inlet member (3) and the sensor arrangement (10) extends over a semidiameter of the gas inlet member (3).

## Revendications

1. Dispositif pour déposer notamment des couches cristallines sur notamment des substrats cristallins, comprenant une chambre de traitement (1) agencée dans une enceinte de réacteur et comportant un porte-substrat (2) pour recevoir un ou plusieurs substrats (8), en face duquel se trouve un organe d'entrée de gaz (3) dont la plaque avant, orientée vers le porte-substrat (2) et formant une surface de sortie de gaz (4), présente une pluralité d'ouvertures de sortie (5) réparties de manière sensiblement uniforme pour la sortie d'un gaz de traitement d'une chambre (7) délimitée par la plaque avant et une paroi arrière (9), une pluralité de capteurs (10) étant prévus qui sont chacun associés à une ouverture de sortie (5) et agencés en alignement avec l'axe de l'ouverture de sortie (5) associée et utilisent les ouvertures de sortie comme chemins optiques pour mesurer la température de surface du support de substrat (2) ou d'un substrat (8) reposant sur le support de substrat (2), **caractérisé en ce que** les capteurs (10) sont situés à l'arrière du panneau avant dans la paroi arrière (9) ou sont agencés à l'arrière d'une ouverture de fenêtre (14) de la paroi arrière (9) fermée par une vitre (15).

2. Dispositif selon la revendication 1, **caractérisé en ce que** les capteurs (10) sont des photodiodes.

3. Dispositif selon l'une des revendications précédentes, **caractérisé en ce que** les capteurs (10) sont montés en formant des rangées sur une carte de circuit imprimé (13).

4. Dispositif selon l'une des revendications précédentes, **caractérisé en ce que** les capteurs (10) sont agencés en décalage mutuel dans deux ou plusieurs rangées s'étendant dans la direction radiale.

5. Dispositif selon l'une des revendications précédentes, **caractérisé en ce que** la chambre de traitement (1) et l'organe d'entrée de gaz (3) ont une configuration symétrique circulaire, le support de substrat (2) peut tourner par rapport à l'organe d'entrée de gaz (3) et l'agencement de capteurs (10) s'étend sur un rayon de l'organe d'entrée de gaz (3).
